# EUROPÄISCHE PATENTSCHRIFT

(11) **EP 1 862 048 B1**
(45) Veröffentlichungstag und Bekanntmachung des Hinweises auf die Patenterteilung: **04.11.2015**
(21) Anmeldenummer: 06725068.8
(22) Anmeldetag: 15.03.2006
(51) Int. Cl.: H05K 13/04

(54) **BESTÜCKAUTOMAT ZUM BESTÜCKEN VON SUBSTRATEN MIT ELEKTRISCHEN BAUELEMENTEN**
PICK-AND-PLACE ROBOT FOR PLACING ELECTRICAL COMPONENTS ON SUBSTRATES
DISPOSITIF AUTOMATIQUE DESTINE A L'EQUIPEMENT DE SUBSTRATS EN COMPOSANTS ELECTRIQUES

(30) Priorität: 22.03.2005 DE 102005013283
(43) Veröffentlichungstag der Anmeldung: 05.12.2007
(73) Patentinhaber: ASM Assembly Systems GmbH & Co. KG, 81379 München (DE)
(72) Erfinder: BLIEM, Thomas, 81379 München (DE); HUBER, Wolfgang, 81379 München (DE); NEGELE, Robert, 85598 Baldham (DE); ROSSMANN, Thomas, 86919 Utting (DE); SATTLER, Klaus, 81549 München (DE)
(74) Vertreter: Kuhlmann, Kai
(86) Internationale Anmeldenummer: PCT/EP2006/060743
(87) Internationale Veröffentlichungsnummer: WO 2006/100199

(56) Entgegenhaltungen:
- WO-A-2004/066700
- DE-A1- 10 302 103
- DE-A1- 19 919 924
- US-A- 5 255 429
- US-B1- 6 618 935

## Beschreibung

Die Erfindung betrifft einen Bestückautomat zum Bestücken von Substraten mit elektrischen Bauelementen.

Bei einem Bestückautomat werden zu bestückende Substrate mittels einer Transportstrecke über Bestückplätze des Bestückautomats transportiert. Seitlich der Transportstrecke sind meist mehrere Zuführeinrichtungen angeordnet, welche elektrische Bauelemente bereitstellen. Ein Bestückkopf kann mittels eines Positioniersystems parallel zur Bestückebene zwischen den Zuführeinrichtungen und den Bestückplätzen des Bestückautomats bewegt werden, um Bauelemente aufzunehmen und auf den Substraten abzusetzen. Der Bestückkopf besteht in der Regel aus einem Grundkörper und einer Vielzahl von Halteeinrichtungen. Die Halteeinrichtungen dienen zur Aufnahme, zum Halten und zur Abgabe der elektrischen Bauelemente und sind drehbar und längsverschieblich am Grundkörper des Bestückkopfes gelagert. Die Bewegung der Halteeinrichtungen erfolgt meist über elektrische Antriebe. Häufig sind für jede Halteeinrichtung ein Drehantrieb und ein Linearantrieb am Bestückkopf vorgesehen. Die Abläufe am Bestückkopf, insbesondere die Bewegungen der Halteeinrichtungen, werden von einer Steuereinrichtung gesteuert. Zur exakten Steuerung ist eine Anzahl von Sensoren für die Positionserfassung der einzelnen Antriebe am Bestückkopf vorgesehen. Die Steuersignale der Steuereinrichtung werden durch eine Leistungselektronik in eine entsprechende Bestromung der elektrischen Antriebe umgesetzt. Aus der obigen Darstellung geht klar hervor, dass aufgrund der sehr umfangreichen Funktionalität moderner Bestückköpfe der gesamte Verdrahtungsaufwand zwischen Steuereinrichtung, der Leistungselektronik, den einzelnen Sensoren und sämtlichen Aktuatoren erheblich ist und eine große Anzahl elektrischer Leitungen erforderlich sind.

In dem Fall, dass die Steuerung des Bestückkopfs von einer zentralen Steuereinheit im Chassis des Bestückautomats durchgeführt wird, muss die gesamte Verdrahtung von der zentralen Steuereinheit entlang der Achsen des Positioniersystems bis zum Bestückkopf geführt werden. Eine derart komplizierte und lange Verdrahtung über bewegliche Teile ist kostspielig und anfällig für Beschädigungen.

Durch die Offenlegungsschrift DE 10302103 ist ein Bestückautomat mit einem abnehmbaren Bestückkopf bekannt geworden, bei dem sich die gesamte Steuerelektronik zum Steuern der Abläufe am Bestückkopf direkt am Bestückkopf angeordnet ist und zusammen mit diesem abgenommen werden kann.

US6,618,935B1 und DE19919924A1 offenbaren ebenfalls Bestückautomaten.

Es ist die Aufgabe der vorliegenden Erfindung, einen alternativen Bestückautomat zu liefern, bei welchem der Verdrahtungsaufwand vom Grundkörper des Bestückautomats zum Bestückkopf verringert wird.

Diese Aufgabe wird durch den Gegenstand des Anspruchs 1 gelöst.

Der erfindungsgemäße Bestückautomat weist eine Montagebasis bzw. ein Montageelement zum Anbringen eines Bestückkopfs am Bestückautomat auf. Der Bestückkopf umfasst einen Grundkörper und mindestens eine Halteeinrichtung, beispielsweise eine Saugpipette, welche mittels einer Antriebseinrichtung relativ zum Grundkörper des Bestückkopfs bewegt werden kann. Der Erfindung liegt die Idee zugrunde, die Steuereinrichtung zum Steuern der Antriebseinrichtung von einer zentralen Steuereinheit des Bestückautomats zu entkoppeln und an der Montagebasis anzuordnen. Die Steuereinrichtung umfasst zumindest die Rechenelektronik zur Berechnung der Steueralgorithmen, also beispielsweise eine Steuerplatine mit einer Rechnereinheit (CPU) und einem Speicherelement. Somit können die Verdrahtungen zwischen der Steuereinrichtung und allen zur Steuerung der Antriebseinrichtung nötigen Komponenten, beispielsweise der Sensoren und der Leistungselektronik, sehr kurz und über Steckerverbindungen realisiert werden, sodass eine komplizierte und kostspielige Führung der gesamten Verdrahtung vom Grundkörper des Bestückautomats zur Montagebasis nicht mehr notwendig ist. Der erfindungsgemäße Bestückautomat zeichnet sich deshalb durch eine kostengünstige und robustere Verdrahtung zwischen der Steuereinrichtung und dem Bestückkopf selbst aus. Ferner entsteht eine universelle Schnittstelle am Bestückkopf, bei der Funktionserweiterungen keine Änderungen in der Grundmaschine bzw. dem Bestückautomat nach sich ziehen.

Vorteilhafte Ausgestaltungen der Erfindung sind Gegenstand der abhängigen Ansprüche.

Bei der Ausgestaltung nach Anspruch 2 wird der Erfindungsgedanke auf einen Bestückautomat angewandt, bei dem der Bestückkopf mittels eines Positioniersystems parallel zur Bestückebene des Bestückautomats bewegt werden kann, und die Montagebasis bzw. das Montageelement deshalb ebenfalls am Positioniersystem angeordnet ist.

Gemäß den Ausgestaltungen nach Anspruch 3 und 4 kann die Antriebseinrichtung sowohl einen Drehantrieb als auch einen Linearantrieb aufweisen.

Gemäß Anspruch 5 kann der erfindungsgemäße Bestückautomat derart ausgebildet sein, dass an der Montagebasis bzw. am Montageelement eine Datenschnittstelle vorgesehen ist, über welche betriebsrelevante Daten zwischen einer Speichereinrichtung eines an der Montagebasis befestigten Bestückkopfs und der Steuereinrichtung übertragbar sind. Diese Ausführungsform des Bestückautomats ist für abnehmbare Bestückköpfe geeignet, deren betriebsrelevante Daten in der direkt am Bestückkopf angeordneten Speichereinrichtung gespeichert sind. Beim Anbringen des Bestückkopfs an der Montagebasis können die Daten dann von der Steuereinrichtung über die Datenschnittstelle aus der Speichereinrichtung ausgelesen werden. Ein derartiger Bestückautomat ist sehr flexibel einsetzbar.

Bei einer Ausgestaltung des Bestückautomats nach Anspruch 6 können die betriebsrelevanten Daten, die in der am Bestückkopf angeordneten Speichereinrichtung abgespeichert sind, geometrische Daten des Bestückkopfs und/oder prozessrelevante Daten aufweisen. Da die geometrischen Daten des Bestückkopfs einfach aus der Speichereinrichtung ausgelesen werden können, wird der Kalibrierungsaufwand nach einem Wechsel des Bestückkopfs deutlich reduziert. Bei den prozessrelevanten Daten kann es sich beispielsweise um die Anzahl abgeworfener Bauteile handeln. Dies erleichtert beim Auslesen der Speichereinrichtung die Fehlererkennung und die Wartung des Bestückkopfs.

Eine Ausgestaltung des Bestückautomats nach Anspruch 7 umfasst eine Druckluftleitung und/oder eine Vakuumleitung, an die der Bestückkopf anschließbar ist. Die Druckluft bzw. das Vakuum dient zum Abblasen bzw. zum Ansaugen der elektrischen Bauelemente von der bzw. an die Halteeinrichtung. Ein in der Druckluftleitung bzw. Vakuumleitung angeordnetes Ventil ist mit der Steuereinrichtung verbunden, so dass die Druckluftzufuhr bzw. die Vakuumzufuhr von der Steuereinrichtung gesteuert werden kann.

Der erfindungsgemäße Bestückautomat kann gemäß Anspruch 8 auch dahingehend ausgestaltet werden, dass die Leistungselektronik, welche die Steuersignale der Steuereinrichtung in eine entsprechende Bestromung der Antriebseinrichtungen umsetzt, im Grundkörper des Bestückautomats angeordnet ist. Die Anzahl der elektrischen Verbindungen zwischen der Steuereinrichtung und der Leistungselektronik bzw. zwischen der Leistungselektronik und der Antriebseinrichtung ist vergleichsweise gering, sodass der Vorteil des geringeren Verdrahtungsaufwands nur unwesentlich wird. Andererseits bietet diese Lösung den Vorteil, dass die zu bewegende Masse am Positioniersystem und auch die Abmessung des Bestückkopfs klein gehalten werden kann.

Gemäß einer Ausgestaltung nach Anspruch 9 kann die Leistungselektronik jedoch alternativ auch an die Montagebasis angebracht werden.

Im Folgenden werden Ausführungsbeispiele des erfindungsgemäßen Bestückautomats mit Bezug auf die beigefügten Figuren näher beschrieben. In den Figuren sind:
Figur 1 eine schematische Ansicht des Bestückautomats,
Figur 2 eine schematische Darstellung eines ersten Ausführungsbeispiels des erfindungsgemäßen Bestückautomats, und
Figur 3 eine schematische Darstellung eines zweiten Ausführungsbeispiels des erfindungsgemäßen Bestückautomats.

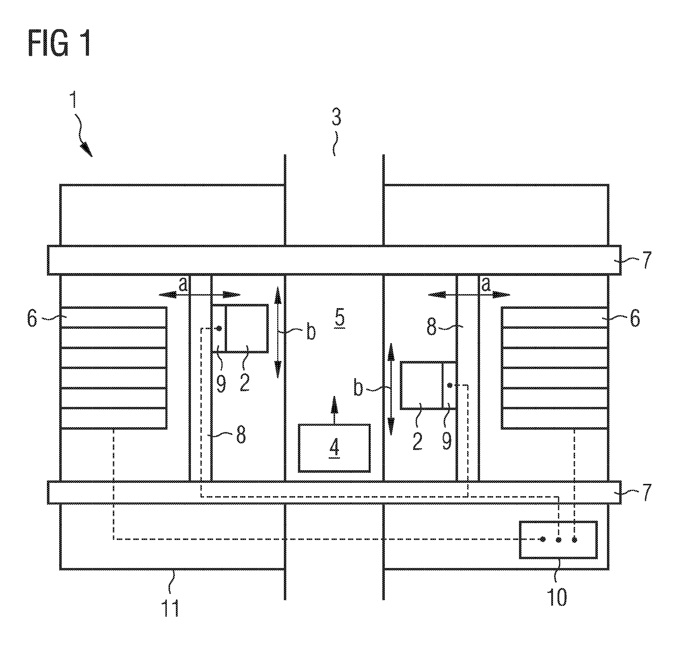

Eine schematische Draufsicht eines Bestücksystems mit einem erfindungsgemäßen Bestückautomat 1 und zwei Bestückköpfen 2 ist in Fig. 1 dargestellt. Der Bestückautomat 1 umfasst eine Transportstrecke 3, auf der zu bestückende Substrate 4 an einen Bestückplatz 5 des Bestückautomats 1 herangeführt und nach dem Bestücken wieder wegtransportiert werden. Seitlich entlang der Transportstrecke 3 weist der Bestückautomat 1 Abholbereiche auf, an denen jeweils mehrere Zuführeinrichtungen 6 vorgesehen sind. Die Zuführeinrichtungen 6 dienen der Zufuhr der elektrischen Bauelemente.

Der Bestückautomat 1 weist ferner ein zweidimensionales Positioniersystem auf, welches aus zwei Querträgern 7 und einem Trägerarm 8 besteht. Die Querträger 7 überspannen die Transportstrecke 3 brückenartig. Der Trägerarm 8 ist an seinen Enden beweglich an den Querträgern 7 befestigt und wird durch einen Linearmotor (in Fig. 1 nicht dargestellt) in Richtung des Doppelpfeils a bewegt. Am Trägerarm 8 ist eine bewegliche Montagebasis 9 bzw. ein Montageelement in Form einer Montageplatte 9 zum Anbringen des Bestückkopfs 2 vorgesehen. Die Montagebasis 9 kann mittels eines Linearmotors (nicht dargestellt) in Richtung des Doppelpfeils b entlang des Trägerarms verfahren werden. Der an der Montageplatte 9 bzw. am Montageelement befestigte Bestückkopf 2 kann so mittels der Positioniereinrichtung parallel zu einer Bestückebene des Bestückautomats 1 zwischen den Abholbereichen, in denen die Bauelemente bereitgestellt werden, und dem in der Bestückebene liegenden Bestückplatz 5, an dem die Substrate 4 bestückt werden, verfahren werden.

Eine zentrale Steuereinheit 10 ist im Grundkörper bzw. im Chassis 11 des Bestückautomats 1 angeordnet. Daneben weist der Bestückautomat 1 noch eine Steuereinrichtung 12 für den Bestückkopf 2 und weitere der zentralen Steuereinheit 10 untergeordnete Steuereinrichtungen, wie beispielsweise für die Zuführeinrichtungen 6 (nicht dargestellt), auf. Während die untergeordneten Steuereinrichtungen sämtliche Abläufe an den jeweiligen Untereinheiten (Bestückkopf 2, Zuführeinrichtungen 6) des Bestücksystems steuern, dient die zentrale Steuereinheit 10 hauptsächlich der Koordinierung der untergeordneten Steuereinrichtungen innerhalb des Bestückprozesses. Zu diesem Zweck ist die zentrale Steuereinheit 10, wie in Fig. 1 durch gestrichelte Linien angedeutet, mit sämtlichen untergeordneten Steuereinrichtungen elektrisch verbunden, um Zeitsteuersignale (Triggersignale) an die untergeordneten Steuereinrichtungen zu senden. Zu den Zeitsteuersignalen zählen beispielsweise ein Startsignal bzw. ein Endsignal, welches der jeweiligen untergeordneten Steuereinrichtung 12 die Aufnahme bzw. das Beenden der Steuerungsvorgänge aufzeigt.

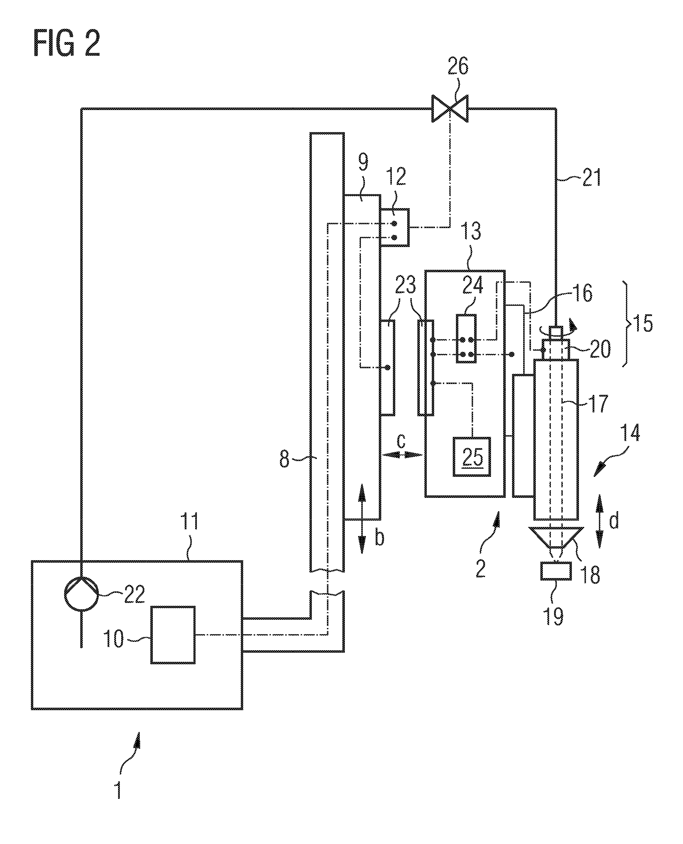

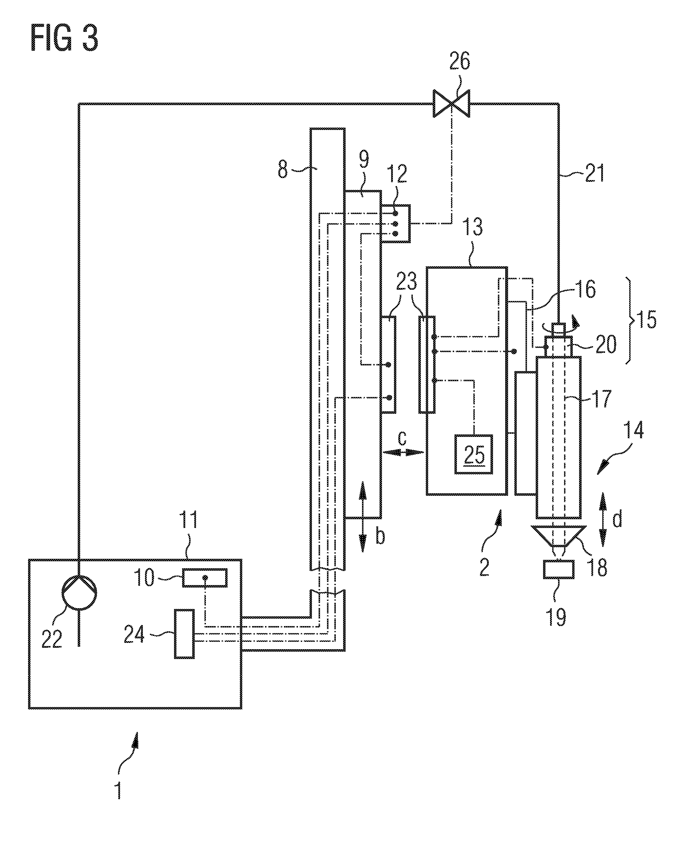

Erfindungsgemäß ist die Steuereinrichtung 12 des Bestückkopfs 2, örtlich getrennt von der zentralen Steuereinheit 10, an der Montageplatte 9 angeordnet und mit der zentralen Steuereinheit 10 verbunden. Die Steuereinrichtung 12 wird im Folgenden in Verbindung mit den Figs. 2 und 3 näher erläutert. Elektrische Leitungen sind in den Figs. 2 und 3 strichpunktiert dargestellt.

In Fig. 2 ist ein erstes Ausführungsbeispiel eines erfindungsgemäßen Bestückautomats 1 dargestellt. Aus Gründen der besseren Übersichtlichkeit ist die Darstellung nicht maßstabsgetreu und sehr schematisch ausgeführt, wobei Bestandteile des Bestückautomats 1, die nicht unbedingt zur Erläuterung der Erfindung notwendig sind, nicht gezeigt sind. Der Bestückautomat 1 ist auf den Grundkörper 11 und den Trägerarm 8 des Positioniersystems reduziert.

Wie oben erwähnt wurde, kann der Bestückkopf 2 an der Montageplatte 9 des Positioniersystems, beispielsweise mittels Schraubverbindungen, lösbar angebracht werden (durch Doppelpfeil c symbolisiert). Zugunsten der besseren Übersichtlichkeit ist der Bestückkopf 2 in den Figs. 2 und 3 getrennt von der Montageplatte dargestellt. Die Montageplatte 9 ist mit einem nicht dargestellten Mobilteil eines Linearmotors, welcher am Trägerarm 8 in bekannter Weise angeordnet ist, verbunden, um den an der Montageplatte 9 befestigten Bestückkopf 2 in der durch den Doppelpfeil b dargestellte Richtung entlang des Trägerarms zu bewegen. Der im rechten Teil der Fig. 2 schematisch dargestellte Bestückkopf 2 besteht im Wesentlichen aus einem Grundkörper 13 bzw. einem Bestückkopfgehäuse, einer Halteeinrichtung 14 und einer Antriebseinrichtung 15 für die Halteeinrichtung 14. Im Ausführungsbeispiel umfasst die Antriebseinrichtung 15 einen am Bestückkopfgehäuse befestigten Linearantrieb 16, beispielsweise einen Linearmotor, um die Halteeinrichtung 14 relativ zum Bestückkopfgehäuse in einer Richtung senkrecht zur Bestückebene zu verfahren (Doppelpfeil d). Die Halteeinrichtung 14, welche eine Saugpipette sein kann, besteht im Wesentlichen aus einer zentral durchgängigen Drehwelle 17, die an ihrem unteren Ende mit einer Halterspitze 18 zum Halten eines elektrischen Bauelements verbunden ist.

Im Ausführungsbeispiel umfasst die Halteeinrichtung 14 zusätzlich zum Linearantrieb 16 einen mit der Drehachse verbundenen Drehantrieb 20, um die Halteeinrichtung 14 relativ zum Bestückkopfgehäuse um die Drehachse zu drehen. Ein an der Halterspitze 18 angesaugtes Bauelement 19 kann dadurch in eine andere Winkellage bewegt werden.

Je nach Anwendungsfall ist es jedoch auch denkbar, dass die Antriebseinrichtung 15 nur den Linearantrieb 16 oder nur den Drehantrieb 20 umfasst.

Zum Aufnehmen, Halten und Abgeben der Bauelemente wird die Halterspitze 18 mit Vakuum und/oder Druckluft beaufschlagt. Dazu ist die Drehwelle 17 als Hohlwelle ausgebildet und über eine Leitung 21 mit einer im Grundkörper 11 des Bestückautomats 1 befindlichen Druckluft- und/oder Vakuumversorgung 22 verbunden.

Erfindungsgemäß befindet sich die Steuereinrichtung 12 zum Steuern der Antriebseinrichtung 15 des Bestückkopfes an der Montageplatte 9 des Bestückautomats 1. Im Falle des Ausführungsbeispiels steuert die Steuereinrichtung 12 den Linearantrieb 16 und den Drehantrieb 20 des Bestückkopfs 2. Die Steuereinrichtung 12 umfasst die zur Berechnung von Steueralgorithmen für die Antriebseinrichtung 15 des Bestückkopfs 2 nötige Elektronik, wie eine Rechnereinheit (CPU) und ein Speicherelement, welche auf einer gemeinsamen Platine angeordnet sein kann. Die Steuereinrichtung 12 ist mit einer ebenfalls an der Montageplatte 9 angeordneten Datenschnittstelle 23 elektrisch verbunden, über welche die entsprechenden Steuersignale auf den an der Montageplatte 9 befestigten Bestückkopf 2 übertragen werden.

In dem in Figur 2 dargestellten ersten Ausführungsbeispiel befindet sich eine Leistungselektronik 24 der zu steuernden Antriebseinrichtung 15 am Bestückkopf 2 und ist über die Datenschnittstelle 23 mit der Steuereinrichtung 12 verbunden. Die Leistungselektronik 24 dient der Umsetzung der Steuersignale der Steuerungseinrichtung in eine entsprechende Bestromung der Antriebseinrichtung 15, und umfasst dazu insbesondere Servoverstärker (nicht dargestellt).

Die Steuereinrichtung 12 ist über eine entlang dem Trägerarm 8 des Positioniersystems geführte elektrische Leitung 21 mit der zentralen Steuereinheit 10 des Bestückautomats 1 verbunden. Die Steuereinrichtung 12 steuert die Antriebseinrichtung 15 des Bestückkopfs 2 in Erwiderung auf die von der zentralen Steuereinheit 10 gesendeten Zeitsteuersignale, welche nur als zeitliche Triggersignale zur Durchführung der Steuerung dienen. Zur genauen Steuerung der Antriebseinrichtung 15 sind am Bestückkopf 2 neben der Antriebseinrichtung 15 auch noch zahlreiche, bekanntermaßen ausgeführte Sensoren, beispielsweise Wegsensoren (in Fig. 2 nicht dargestellt), zur Überwachung der Antriebseinrichtung 15 am Bestückkopf 2 angeordnet und über die Datenschnittstelle 23 mit der Steuereinrichtung 12 elektrisch verbunden. So wird eine exakte Regelung der Antriebseinrichtung 15 realisiert.

In einer vorteilhaften Ausgestaltung kann am Bestückkopf 2 eine Speichereinrichtung 25 angeordnet sein, in der bestückkopfspezifische Daten, wie beispielsweise geometrische Abmessungen oder sonstige betriebsrelevante Daten des Bestückkopfs 2, abgespeichert sind. Im montierten Zustand kann die Steuereinrichtung 12 über die Datenschnittstelle 23 die Daten aus der Speichereinrichtung 25 auslesen und die Steueralgorithmen der Antriebseinrichtung 15 entsprechend anpassen.

Des Weiteren kann in der Druckluft- bzw. Vakuumleitung, welche von der Druckluft- bzw. Vakuumversorgung 22 im Bestückautomat 1 zur Halteeinrichtung 14 des Bestückkopfes führt, ein steuerbares Ventil 26 angeordnet sein, welches ebenfalls von der Steuereinrichtung 12 gesteuert wird. Das Ventil 26 kann sich sowohl außerhalb des Bestückkopfes oder auch am Bestückkopf 2 selbst befinden. Im letzten Fall würde die elektrische Verbindung zwischen der Steuereinrichtung 12 und dem Ventil 26 über die Datenschnittstelle 23 erfolgen. Dadurch ist es möglich, dass die Druckluft- bzw. Vakuumzufuhr zur Halterspitze 18 je nach Bedarf eingestellt werden kann. Beispielsweise wird zum Aufnehmen eines elektrischen Bauelementes die Halterspitze 18 mit Vakuum und zum Bestücken die Halterspitze 18 mit Druckluft beaufschlagt.

Durch die erfindungsgemäße Anordnung der Steuereinrichtung 12 an der Montageplatte 9 kann der Verdrahtungsaufwand von der zentralen Steuereinheit 10 im Chassis 11 des Bestückautomats 1 über das Positioniersystem zum Bestückkopf 2 erheblich reduziert werden. Dies ist darauf zurückzuführen, dass die Verdrahtung zwischen der Steuereinrichtung 12 und dem Bestückkopf 2, welche einen Großteil des Gesamtverdrahtungsaufwands darstellt, nur noch über sehr kurze Leitungen von der Montageplatte 9 über die Datenschnittstelle 23 zum Bestückkopf 2 geführt werden muss. Dadurch können die Kosten für eine lange und aufwendige Verdrahtung und die Störanfälligkeit des Bestückautomats 1 erheblich reduziert werden.

Beim ersten Ausführungsbeispiel ist es auch möglich, dass die an der Montageplatte 9 befestigte Steuereinrichtung 12 nicht nur die Antriebseinrichtung 15 des Bestückkopfs 2 steuert, sondern auch weitere oder sämtliche am Bestückkopf 2 befindliche Aktuatoren bzw. Sensoren.

Das in Fig. 3 dargestellte zweite Ausführungsbeispiel des erfindungsgemäßen Bestückautomats 1 unterscheidet sich von dem ersten Ausführungsbeispiel gemäß Fig. 2 lediglich dadurch, dass sich die Leistungselektronik 24 für die Antriebseinrichtung 15 am Bestückkopf 2 im Grundkörper, d.h. im Chassis 11 des Bestückautomats 1, befindet. Durch die Verlagerung der Leistungselektronik 24 in das Chassis 11 kann die zu bewegende Masse am Positioniersystem reduziert werden, was sich positiv auf die Bestückleistung des Bestückautomats 1 auswirkt. Der oben genannte Vorteil der Verringerung der über das Positioniersystem geführten Verdrahtung wird dabei kaum geschmälert, da nur eine relativ geringfügige Anzahl elektrischer Leitungen von der Steuereinrichtung 12 zur Leistungselektronik 24 und von dieser zu den Antriebseinrichtungen am Bestückkopf 2 geführt werden muss. Ansonsten gelten für das zweite Ausführungsbeispiel die bezüglich des ersten Ausführungsbeispiels aufgeführten Merkmale.

Als eine weitere Alternative ist es auch möglich, die Leistungselektronik 24 für die Antriebe des Bestückkopfes zusammen mit der Steuereinrichtung 12 an der Montageplatte 9 des Bestückautomats 1 vorzusehen. Hierbei ergeben sich analog die oben genannten Vorteile.

In den Ausführungsbeispielen weist der Bestückkopf 2 eine einzige Halteeinrichtung 14 auf. Der Erfindungsgedanke kann jedoch auch auf einen Bestückkopf mit mehreren Halteeinrichtungen, die entweder matrixartig (Matrix-Bestückkopf)in einer Ebene oder revolverförmig (Revolver-Bestückkopf) umlaufend am Grundkörper des Bestückkopfs angebracht sind, angewandt werden. In Falle eines Bestückkopfs mit mehreren Halteeinrichtungen steuert die an der Montagebasis angebrachte Steuereinrichtung analog zu den Ausführungsbeispielen zumindest die Antriebseinrichtungen der einzelnen Halteeinrichtungen.

### Bezugszeichenliste:

- 1: Bestückautomat
- 2: Bestückkopf
- 3: Transportstrecke
- 4: Substrat
- 5: Bestückplatz
- 6: Zuführeinrichtung
- 7: Querträger
- 8: Trägerarm
- 9: Montagebasis/Montageplatte
- 10: Zentrale Steuereinheit
- 11: Grundkörper/Chassis des Bestückautomats
- 12: Steuereinrichtung für Bestückkopf
- 13: Grundkörper des Bestückkopfs
- 14: Halteeinrichtung
- 15: Antriebseinrichtung
- 16: Linearantrieb
- 17: Drehwelle
- 18: Halterspitze
- 19: Bauelement
- 20: Drehantrieb
- 21: Leitung
- 22: Druckluft-/Vakuumversorgung
- 23: Datenschnittstelle
- 24: Leistungselektronik
- 25: Speichereinrichtung
- 26: Ventil

## Patentansprüche

1. Bestückautomat (1) zum Bestücken von Substraten mit elektrischen Bauelementen, mit einer zentralen Steuereinheit (10), einer Montagebasis (9) zum Anbringen eines Bestückkopfs (2) an den Bestückautomat (1), wobei der Bestückkopf (2) eine beweglich gelagerte Halteeinrichtung (14) zum Halten der Bauelemente und eine Antriebseinrichtung (15) zum Bewegen der Halteinrichtung relativ zu einem Grundkörper des Bestückkopfs (2) aufweist,
und eine Steuereinrichtung (12) zum Steuern der Antriebseinrichtung (15) , wobei die Steuereinrichtung (12) von der zentralen Steuereinheit (10) örtlich getrennt und zur Ansteuerung durch die zentrale Steuereinheit (10) elektrisch mit der zentralen Steuereinheit (10) verbunden ist
**dadurch gekennzeichnet, dass** die Steuereinrichtung (12) zum Steuern der Antriebseinrichtung (15) direkt an der Montagebasis (9) angeordnet ist.

2. Bestückautomat (1) nach Anspruch 1, **dadurch gekennzeichnet, dass** die Montagebasis (9) an einem Positioniersystem (7,8) des Bestückautomats (1) angeordnet ist, mittels der die Montagebasis (9) parallel zu einer Bestückebene des Bestückautomats (1) verfahrbar ist.

3. Bestückautomat (1) nach einem der Ansprüche 1 bis 2, **dadurch gekennzeichnet, dass** die Antriebseinrichtung (15) einen Drehantrieb (20) zum Drehen der Halteeinrichtung (14) umfasst.

4. Bestückautomat (1) nach einem der Ansprüche 1 bis 3, **dadurch gekennzeichnet, dass** die Antriebseinrichtung (15) einen Linearantrieb (16) zum Bewegen der Halteeinrichtung (14) in einer Richtung senkrecht zu einer Bestückebene des Bestückautomats (1) aufweist.

5. Bestückautomat (1) nach einem der Ansprüche 1 bis 4, **dadurch gekennzeichnet, dass** eine an der Montagebasis (9) angeordnete Datenschnittstelle (23) derart ausgebildet ist, dass betriebsrelevante Daten zwischen einer Speichereinrichtung (25) des Bestückkopfs (2), der an der Montagebasis (9) befestigt ist, und der Steuereinrichtung (12) übertragbar sind.

6. Bestückautomat (1) nach Anspruch 5, wobei die betriebsrelevanten Daten geometrische Daten des Bestückkopfs (2) und/oder prozessbezogene Daten aufweisen.

7. Bestückautomat (1) nach einem der Ansprüche 1 bis 5, **gekennzeichnet durch** eine Druckluftversorgung (22) und/oder eine Vakuumversorgung (22), an die der Bestückkopf (2) anschließbar ist, wobei die Druckluftzufuhr und/oder die Vakuumzufuhr mittels eines in der Druckluftleitung und/oder in der Vakuumleitung angeordneten Ventils **durch** die Steuereinrichtung (12) steuerbar ist.

8. Bestückautomat (1) nach einem der Ansprüche 1 bis 7, **dadurch gekennzeichnet, dass** eine mit der Steuereinrichtung (12) verbundene Leistungselektronik (24) der Antriebseinrichtung (15) in einem Grundkörper (11) des Bestückautomats (1) angeordnet ist.

9. Bestückautomat (1) nach einem der Ansprüche 1 bis 7, **dadurch gekennzeichnet, dass** eine mit der Steuereinrichtung (12) verbundene Leistungselektronik (24) der Antriebseinrichtung (15) an der Montagebasis (9) angeordnet ist.

## Claims

1. A pick-and-place machine (1) for mounting electrical components to substrates, with a central control unit (10), a mounting base (9) for purposes of mounting a pick-and-place head (2) onto the pick-and-place machine (1), wherein
the pick-and-place head (2) has a holding device (14), mounted such that it can be moved, for purposes of holding the components, and a drive device (15) for purposes of moving the holding device relative to a base body of the pick-and-place head (2), and a control device (12) for purposes of controlling the drive device (15), wherein
the control device (12) is spatially separated from the central control unit (10) and for purposes of enabling control by the central control unit (10) is electrically connected with the central control unit (10),
**characterised in that**,
the control device (12) for purposes of controlling the drive device (15) is arranged directly on the mounting base (9).

2. The pick-and-place machine (1) in accordance with claim 1,
**characterised in that**,
the mounting base (9) is arranged on a positioning system (7, 8) of the pick-and-place machine (1), by means of which the mounting base (9) can be moved parallel to a placement plane of the pick-and-place machine (1).

3. The pick-and-place machine (1) in accordance with one of the claims 1 to 2,
**characterised in that**,
the drive device (15) comprises a rotary drive (20) for purposes of rotating the holding device (14).

4. The pick-and-place machine (1) in accordance with one of the claims 1 to 3,
**characterised in that**,
the drive device (15) has a linear drive (16) for purposes of moving the holding device (14) in a direction at right angles to a placement plane of the pick-and-place machine (1).

5. The pick-and-place machine (1) in accordance with one of the claims 1 to 4,
**characterised in that**,
a data interface (23), arranged on the mounting base (9) is designed such that data relevant to the operation can be transferred between a storage device (25) of the pick-and-place head (2), which is attached to the mounting base (9), and the control device (12).

6. The pick-and-place machine (1) in accordance with claim 5, wherein
the data relevant to the operation include geometric data for the pick-and-place head (2) and/or process-related data.

7. The pick-and-place machine (1) in accordance with one of the claims 1 to 5,
**characterised by**
a compressed air supply (22) and/or a vacuum supply (22), to which the pick-and-place head (2) can be connected, wherein
the supply of compressed air and/or vacuum can be controlled by the control device (12), by means of a valve arranged in the compressed air line and/or in the vacuum line.

8. The pick-and-place machine (1) in accordance with one of the claims 1 to 7,
**characterised in that**,
power electronics (24) of the drive device (15), connected with the control device (12), is arranged in a base body (11) of the pick-and-place machine (1).

9. The pick-and-place machine (1) in accordance with one of the claims 1 to 7,
**characterised in that**,
power electronics (24) of the drive device (15), connected with the control device (12), is arranged on the mounting base (9).

## Revendications

1. Machine automatique à implanter les composants (1) pour mettre en place des composants électriques sur des substrats, avec une unité de commande centrale (10), une base de montage (9) pour monter une tête d'implantation (2) sur la machine automatique à implanter les composants (1), pour laquelle la tête d'implantation (2) comporte un dispositif de maintien monté mobile (14) pour maintenir les composants et un dispositif d'entraînement (15) pour déplacer le dispositif de maintien par rapport à un corps de base de la tête d'implantation (2) et un dispositif de commande (12) pour commander le dispositif d'entraînement (15), pour laquelle le dispositif de commande (12) est localement séparé de l'unité de commande centrale (10) et est reliée électriquement à l'unité de commande centrale (10) pour commander par l'intermédiaire de l'unité de commande centrale (10), **caractérisée en ce que** le dispositif de commande (12) est disposé directement sur la base de montage (9) pour commander le dispositif d'entraînement (15).

2. Machine automatique à implanter les composants (1) selon la revendication 1 **caractérisée en ce que** la base de montage (9) est disposée sur un système de positionnement (7,8) de la machine automatique à impanter les composants (1) au moyen de laquelle la base de montage (9) peut être déplacée parallèlement à un plan d'implantation de la machine automatique à implanter les composants (1).

3. Machine automatique à implanter les composants (1) selon l'une quelconque des revendications 1 à 2 **caractérisée en ce que** le dispositif d'entraînement (15) comprend un entraînement rotatif (20) pour faire tourner le dispositif de maintien (14).

4. Machine automatique à implanter les composants (1) selon l'une quelconque des revendications 1 à 3 **caractérisée en ce que** le dispositif d'entraînement (15) comporte un entraînement linéaire (16) pour déplacer le dispositif de maintien (14) dans une direction perpendiculairement à un plan d'implantation de la machine automatique à implanter les composants (1).

5. Machine automatique à implanter les composants (1) selon l'une quelconque des revendications 1 à 4 **caractérisée en ce qu'**une interface de données (23) disposée sur la base de montage (9) est constituée de telle manière que des données concernant le fonctionnement peuvent être transmises entre un dispositif de mémorisation (25) de la tête d'implantation (2), fixé sur la base de montage (9), et le dispositif de commande (12).

6. Machine automatique à implanter les composants (1) selon la revendication 5 pour laquelle les données concernant le fonctionnement comportent les données géométriques de la tête d'implantation (2) et/ou des données relatives au processus.

7. Machine automatique à implanter les composants (1) selon l'une quelconque des revendications 1 à 5 **caractérisée par** une alimentation en air comprimé (22) et/ou une alimentation en vide (22), auxquelles la tête d'implantation (2) peut être raccordée, pour laquelle l'alimentation en air comprimé et/ou l'alimentation en vide peuvent être commandées par le dispositif de commande (12) au moyen d'une vanne disposée dans le conduit d'air comprimé et/ou dans le conduit de vide.

8. Machine automatique à implanter les composants (1) selon l'une quelconque des revendications 1 à 7 **caractérisée en ce qu'**un système électronique de puissance (24) du dispositif d'entraînement (15) raccordé au dispositif de commande (12) est disposé dans un corps de base (11) de la machine automatique à implanter les composants (1).

9. Machine automatique à implanter les composants (1) selon l'une quelconque des revendications 1 à 7 caractérisée ne ce qu'un système électronique de puissance (24) du dispositif d'entraînement (15), relié au dispositif de commande (12), est disposé sur la base de montage (9).
